**Europäisches Patentamt**

**European Patent Office**

**Office européen des brevets**

(19)

(11) Veröffentlichungsnummer: **0 158 965**
**B1**

## EUROPÄISCHE PATENTSCHRIFT

(12)

(45) Veröffentlichungstag der Patentschrift:
**24.08.88**

(51) Int. Cl.⁴: **G 01 N 24/08**

(21) Anmeldenummer: **85104326.5**

(22) Anmeldetag: **10.04.85**

(54) **Verfahren zum Anregen einer Probe für die NMR-Tomographie.**

(30) Priorität: **18.04.84 DE 3414634**

(43) Veröffentlichungstag der Anmeldung:
**23.10.85 Patentblatt 85/43**

(45) Bekanntmachung des Hinweises auf die Patenterteilung:
**24.08.88 Patentblatt 88/34**

(84) Benannte Vertragsstaaten:
**FR GB NL**

(56) Entgegenhaltungen:
**EP - A - 0 074 022**
**EP - A - 0 088 970**
**EP - A - 0 098 426**

**MEDICAL PHYSICS, Band 10, Nr. 5, September-Oktober 1983, Seiten 642-645, American Association of Physics and Medicine, New York, US; N.J. SCHNEIDERS et al.: " Accurate T2NMR images"**

(73) Patentinhaber: **Bruker Medizintechnik GmbH,
Silberstreifen, D-7512 Rheinstetten-Forchheim (DE)**

(72) Erfinder: **Ströbel, Bernhard, Esterwaystrasse 67,
D-7517 Waldbronn 3 (DE)**
Erfinder: **Ratzel, Dieter, Buchenweg 31,
D-7512 Rheinstetten 4 (DE)**

(74) Vertreter: **Patentanwälte Kohler - Schwindling - Späth,
Hohentwielstrasse 41, D-7000 Stuttgart 1 (DE)**

## Beschreibung

Die Erfindung betrifft ein Verfahren zum Anregen einer Probe für die NMR-Tomographie, bei dem die Probe außer einem homogenen Magnetfeld einem Selektionsgradienten ausgesetzt und mit einem 90°-Selektionsimpuls angeregt, danach der Selektionsgradient durch einen zeitlich begrenzten Phasenkodierungsgradienten und einen Lesegradienten ersetzt, wobei Selektionsgradient, Phasenkodierungsgradient und Lesegradient jeweils paarweise zueinander senkrecht stehen, und schließlich die Probe nach Beendigung der Phasenkodierungsgradienten bei herrschendem Lesegradienten mit einer Folge von 180°-Impulsen bestrahlt wird, wodurch meßbare Kerninduktionssignale in Form sogenannter Spinechos erzeugt werden.

Die Erzeugung und Messung von Kernresonanzsignalen nach Beeinflussung der Probe durch eine vor Einschalten des Lesegradienten angelegten, zeitlich begrenzten Phasenkodierungsgradienten führt durch Anwenden einer zweidimensionalen Fourier-Transformation zur Erzeugung von Querschnittsbildern, weshalb dieses Verfahren auch 2DFT genannt wird. Wie oben angegeben, ist es grundsätzlich denkbar, zur Erzeugung der Kerninduktionssignale die allgemein in der NMR-Spektrometrie verwendeten Spinecho-Impulsfolgen zu verwenden, wie insbesondere die Carr-Purcell-Impulsfolge oder die Carr-Purcell-Gill-Meiboom-Impulsfolge. Diese Impulsfolgen ermöglichen die Erzeugung einer Vielzahl von Echosignalen nach einer gemeinsamen Anregung, welche zur Verbesserung des Signal-Rausch-Verhältnisses aufaddiert oder aber zur Bestimmung der Spin-Spin-Relaxationszeit $T_2$ verwendet werden können. Es hat sich jedoch gezeigt, daß bei Anwendung der 2DFT-Methode die bisher bekannten Impulsfolgen nur beschränkt anwendbar sind, da mit wachsender Anzahl der Echos in zunehmendem Maße Artefakte in Form von Bildern auftreten, welche gegenüber dem ungestörten Bild an einer zur Richtung des Lesegradienten parallelen Achse gespiegelt sind. Derartige Artefakte werden im folgenden Spiegelbilder genannt.

Da andererseits beispielsweise eine genaue $T_2$-Bestimmung oder eine Analyse nach verschiedenen $T_2$-Beiträgen bei einer multiexponentiellen Spin-Spin-Relaxation nur mit Hilfe vieler Spinechos durchführbar ist, war das 2DFT-Verfahren für solche Untersuchungen, welche von großer Bedeutung in der diagnostischen Medizin sind, bisher nicht einsetzbar, obwohl es den Vorteil hat, schon bei relativ geringer Homogenität des Magnetfeldes gute Bilder zu liefern, so daß dieses Verfahren unter anderem für einfachere Anlagen aus dieser Sicht heraus besonders gut geeignet wäre.

Demgemäß liegt der Erfindung die Aufgabe zugrunde, das Verfahren der eingangs genannten Art so zu verbessern, daß bei der Anwendung von Spinecho-Impulsfolgen keine Spiegelbilder mehr entstehen.

Diese Aufgabe wird nach der Erfindung dadurch gelöst, daß die Probe im Verlauf einer Spinecho-Impulsfolge der Einwirkung des Phasenkodierungsgradienten derart ausgesetzt wird, daß die zwischen je zwei 180°-Impulsen durch den Phasenkodierungsgradienten bewirkte Dephasierung doppelt so groß ist wie die vor dem ersten 180°-Impuls durch den Phasenkodierungsgradienten bewirkte Dephasierung.

Es ist in der NMR-Tomographie wie auch in der NMR-Spektroskopie bekannt, daß bei Verwendung einer Spinecho-Impulsfolge die Rephasierungsbedingung für den Lesegradienten erfüllt sein muß. Dies wird am einfachsten dadurch erreicht, daß bei konstant anstehendem Lesegradienten der zeitliche Abstand zweier benachbarter 180°-Impulse doppelt so groß gewählt wird wie der Abstand zwischen dem Beginn der Dephasierung durch den Lesegradienten und dem ersten 180°-Impuls.

Das erfindungsgemäße Verfahren hat zur Folge, daß die Rephasierungsbedingungen nicht nur für den Lesegradienten, sondern auch für den Phasenkodierungsgradienten erfüllt wird. Dabei erfolgt jedoch der Meßvorgang nur unter Anwesenheit des Lesegradienten, während der Phasenkodierungsgradient so geschaltet wird, daß durch diesen Gradienten eine während der Dauer eines jeden Meßvorganges konstante und für alle Meßvorgänge innerhalb einer Spinecho-Impulssequenz gleiche Dephasierung bewirkt wird. Dies wird durch ein wiederholtes Einschalten des Phasenkodierungsgradienten zwischen je zwei 180°-Impulsen in einer der im folgenden beschriebenen Weisen erreicht.

Nach einer ersten Ausführungsform der Erfindung wird der Phasenkodierungsgradient vor Beginn des ersten 180°-Impulses erstmals eingeschaltet, wodurch eine gewisse Dephasierung bewirkt wird, und anschließend zwischen je zwei 180°-Impulsen, jedoch nach Beendigung des Meßvorgangs für jedes Spinecho, erneut eingeschaltet, so daß die hierdurch bewirkte Dephasierung doppelt so groß ist wie die während der ersten Einwirkung des Phasenkodierungsgradienten vor dem ersten 180°-Impuls bewirkte Dephasierung.

Nach einer zweiten Ausführungsform der Erfindung wird der Phasenkodierungsgradient vor Beginn des ersten 180°-Impulses erstmals eingeschaltet, wodurch eine gewisse Dephasierung bewirkt wird, und anschließend zwischen je zwei 180°-Impulsen, jedoch vor Beginn des Meßvorganges für jedes Spinecho, erneut eingeschaltet, so daß die hierdurch bewirkte Dephasierung doppelt so groß ist wie die während der ersten Einwirkung des Phasenkodierungsgradienten vor dem ersten 180°-Impuls bewirkte Dephasierung.

Nach einer dritten Ausführungsform der Erfindung wird der Phasenkodierungsgradient vor dem ersten 180°-Impuls überhaupt nicht, sondern erstmals nach dem ersten 180°-Impuls eingeschaltet, und zwar derart, dass er zwischen je zwei 180°-Impulsen zunächst vor Beginn des Meßvorganges eingeschaltet wird, so dass eine gewisse Dephasierung bewirkt wird, und anschließend nach Ende des Meßvorganges, jedoch vor Beginn des nächsten 180°-Impulses, erneut mit umgekehrtem Vorzeichen eingeschaltet wird, so daß diese zweite Einwirkung des Gradienten die durch die erste Einwirkung bewirkte Dephasierung wieder aufhebt.

Das erfindungsgemäße Verfahren ermöglicht insbesondere die Verwendung einer herkömmlichen Carr-Purcell-Gill-Meiboom-Impulsfolge für die NMR-Tomographie nach dem 2DFT-Verfahren. Durch die Einhaltung der Rephasierungsbedingung auch für den Phasenkodierungsgradienten werden die Effekte, welche zu einer Spiegelbildung führen, aufgehoben. Dabei kann der Phasenkodierungsgradient ohne weiteres zusätzlich zum Lesegradienten eingeschaltet sein, weil bei dem 2DFT-Verfahren die Wirkung beider Gradienten voneinander unabhängig ist.

Die Erfindung wir im folgenden anhand der in der Zeichnung dargestellten Diagramme näher beschrieben und erläutert. Es zeigen:

Figur 1 ein Zeitdiagramm der Gradientenfelder und Signale bei einem herkömmlichen 2DFT-Verfahren unter Verwendung einer Carr-Purcell-Gill-Meiboom-Impulsfolge,

Figur 2 Zeigerdiagramme zur Veranschaulichung der unter Verwendung des Verfahrens nach Figur 1 in die X,Y-Ebene gedrehten Spinmomente,

Figur 3 Zeigerdiagramme der in Figur 2 dargestellten Spinmomente in der X,Z-Ebene,

Figur 4 Zeigerdiagramme zur Erläuterung der Entstehung von Spiegelbildern,

Figur 5 ein Zeitdiagramm zur Erläuterung einer ersten Ausführungsform des erfindungsgemäßen Verfahrens,

Figur 6 ein Zeitdiagramm zur Erläuterung einer zweiten Ausführungsform des erfindungsgemäßen Verfahrens und

Figur 7 ein Zeitdiagramm zur Erläuterung einer dritten Ausführungsform des erfindungsgemäßen Verfahrens.

Wie bekannt, wird bei der NMR-Tomographie eine zu untersuchende Probe, insbesondere ein menschlicher Körper oder ein Körperteil, in ein starkes homogenes Magnetfeld $B_0$ gebracht, dessen Richtung gewöhnlich die Z-Achse eines rechtwinkligen Koordinatensystems zugeordnet wird. Durch die Einwirkung dieses Magnetfeldes sind die magnetischen Spinmomente der Atomkerne in der Probe normalerweise, d.h. ohne eine zusätzliche äußere Einwirkung, in Z-Richtung ausgerichtet. Die zur Herstellung eines Bildes benötigte Information kann jedoch nur aus den HF-Signalen gewonnen werden, welche von den in der X,Y-Ebene um die Z-Richtung rotierenden, zu Z senkrechten Komponenten der Spinmomente erzeugt werden. Diese Signale werden Kerninduktionssignale genannt. Daher müssen die Spinmomente in den abzubildenden Bereichen der Probe durch Einstrahlen von Hochfrequenz in geeigneter Weise aus der Z-Richtung herausgedreht werden, vorzugsweise um 90° bis in die X,Y-Ebene.

Für die Abbildung eines Querschnitts der zu untersuchenden Probe müssen daher die Spinmomente innerhalb einer ausgewählten Scheibe der Probe möglichst vollständig in dier X,Y-Ebene gedreht werden, wohingegen die Spinmomente außerhalb der Scheibe möglichst vollständig in der Z-Richtung ausgerichtet bleiben müssen. Dieser Vorgang wird selektive Anregung der Spinmomente genannt; der Zeitabschnitt innerhalb eines tomographischen Verfahrens, in welchem die selektive Anregung erfolgt, wird Selektionsphase genannt.

Die in die X,Y-Ebene gedrehten Spinmomente werden beim 2DFT-Verfahren der dephasierenden Wirkung der als Phasenkodierungsgradient und als Lesegradient bezeichneten Gradientenfelder ausgesetzt. Da die zur Herstellung eines Bildes benötigte Information aus dem Einfluß dieser Dephasierung auf die zu beobachtenden Kerninduktionssignale gewonnen wird, muß die selektive Anregung so erfolgen, daß durch sie die anzuregenden Spinmomente möglichst weitgehend in Phase in die X,Y-Ebene gedreht werden, das heißt, daß sie ohne den Einfluß von Phasenkodierungsgradient oder Lesegradient möglichst gleichphasig um die Z-Richtung rotieren.

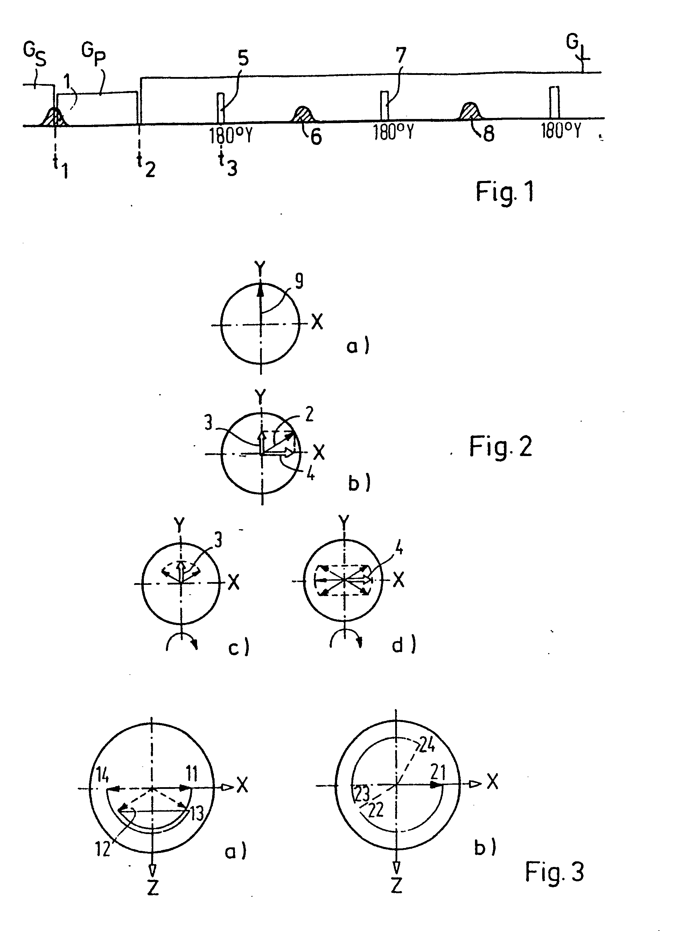

Ein bekanntes Verfahren zur selektiven Anregung, das diese Bedingung erfüllt, besteht darin, dem homogenen Magnetfeld $B_0$ ein magnetisches Gradientenfeld zu überlagern, das ebenfalls parallel zur Z-Richtung ausgerichtet ist, dessen Stärke sich aber längs einer Richtung, die senkrecht auf der für das Bild ausgewählten Querschnittsebene steht, ändert. Dieses Gradientenfeld wird Selektionsgradient genannt. Unter dem Einfluss der anliegenden Magnetfelder ändert sich die Larmorfrequenz der Spinmomente in der Probe längs der Richtung der Selektionsgradienten. (Die Richtung, in der sich die magnetische Feldstärke bei Vorhandensein eines Gradientenfeldes ändert, wird hier und im folgenden kurz als Richtung dieses Gradienten bezeichnet.) Durch Einstrahlen eines schmalbandigen HF-Impulses lassen sich daher die Spinmomente innerhalb einer zur Richtung des Selektionsgradienten senkrechten Scheibe der Probe, deren Dicke durch die Bandbreite des HF-Impulses gegeben ist, um einen Winkel $\alpha$ aus der Richtung der Z-Achse heraus, vorzugsweise bei entsprechender Dimensionierung des Impulses, um den Winkel 90° bis in die X,Y-Ebene drehen. Im folgenden wird ein Impuls, der die Spinmomente um den Winkel $\alpha$ dreht, als $\alpha$-Impuls bezeichnet. Nach Beendigung des selektiven 90°-Impulses wird nach dem bekannten Verfahren die Richtung des Selektionsgradienten umgekehrt, um so eine Rephasierung der während der Dauer des 90°-Impulses unter dem Einfluß des Selektionsgradienten dephasierten Spinmomente innerhalb der Scheibe zu bewirken. Eine weitere Möglichkeit der Rephasierung besteht in der Anwendung eines 180°-Impulses nach Beendigung des 90°-Impulses bei unverändert anstehendem Selektionsgradienten. In beiden Fällen wird zum Zeitpunkt der vollständig erfolgten Rephasierung der Selektionsgradient ausgeschaltet. Dieser Zeitpunkt stellt das Ende der Selektionsphase dar; er ist in dem Diagramm nach Figur 1 mit $t_1$ gekennzeichnet. Die vollständige Rephasierung der Spinmomente zum Zeitpunkt $t_1$ ist mit dem Auftreten eines Kerninduktionssignals in Form eines sogenannten Spinechos 1 verbunden.

Die Selektionsphase ist jedoch nicht Gegenstand dieser Erfindung. Daher ist sie auf dem Diagramm nach Figur 1 nicht vollständig dargestellt. Im folgenden wird lediglich angenommen, daß während der Selektionsphase in der vorstehend beschriebenen oder in einer anderen Weise die Spinmomente innerhalb der abzubildenden Scheibe möglichst vollständig und so in die X,Y-Ebene gedreht worden sind, daß sie zum Zeitpunkt $t_1$ in Phase um die Z-Richtung rotieren.

Die Phasenlage der Spinmomente innerhalb der X,Y-Ebene wird, wie allgemein üblich, mit Hilfe eines mit der Larmorfrequenz von $B_O$ um die Richtung der Z-Achse rotierenden Koordinatensystems beschrieben. Die Richtungen in diesem System werden im folgenden mit X, Y und Z bezeichnet, wobei die Z-Richtung feststeht und die X- und Y-Richtungen in der X,Y-Ebene rotieren. (In einem ruhenden Koordinatensystem stellen die Richtungen X und Y Phasenlagen einer mit Larmorfrequenz um die Richtung der Z-Achse erfolgenden Präzessionsbewegung dar.) Die X-Richtung sei im folgenden durch die Annahme festgelegt, daß die selektive Anregung durch einen 90°,X-Impuls stattgefunden hat. Hierunter soll ein Impuls verstanden werden, der die Spinmomente um 90° um die Richtung von X dreht, so daß sie zur Zeit $t_1$ in die Y-Richtung des rotierenden Koordinatensystems deuten. Diese Phasenlage der Spinmomente zur Zeit $t_1$ ist in Figur 2a unter 9 dargestellt.

Im Zeitpunkt $t_1$ wird der Phasenkodierungsgradient $G_P$ eingeschaltet, der eine dephasierende Wirkung derart hat, daß an seinem Ende im Zeitpunkt $t_2$ die Phasenlage bestimmter Spinmomente z.B. in die Richtung des Pfeiles 2 gedreht worden ist (Fig. 2b). Das 2DFT-Verfahren beruht darauf, daß mittels Variation von Dauer oder Intensität des Phasenkodierungsgradienten $G_P$ unterschiedliche Phasenlagen eingestellt werden, welche unterschiedliche Intensitäten der unter dem Lesegradienten $G_L$ gemessenen Signale ergeben, die nach entsprechender Verarbeitung der Signale die bildliche Darstellung einer Querschnittsebene der Probe ermöglichen.

Wie in Figur 2b dargestellt, kann das Spinmoment 2 in eine Y-Komponente 3 und in eine X-Komponente 4 zerlegt werden. Bezüglich dieser Komponenten tritt bis zur Zeit $t_3$ des ersten 180°-Impulses eine Dephasierung der Spinmomente ein, welche auf die Variation des Magnetfeldes unter dem im Zeitpunkt $t_2$ eingeschalteten Lesegradienten $G_L$ und auch auf Feld-Inhomogenitäten zurückzuführen ist. Die Dephasierung für die Y- und die X-Komponente im Zeitpunkt $t_3$ ist in Figur 2c bzw. 2d dargestellt. Der 180°-Impuls im Zeitpunkt $t_3$ dient in herkömmlicher Weise dazu, die Dephasierung rückfängig zu machen, so daß es eine gewisse Zeit nach dem 180°-Impuls 5 zur Erzeugung eines Echosignals 6 kommt. Bei dem dargestellten Ausführungsbeispiel sei der Impuls 5 ein 180°,Y-Impuls, welcher eine Drehung der Spinmomente um 180° un die Y-Achse bewirkt. Um diese Drehung zu veranschaulichen, sind die Spinmomente der Figuren 2c und 2d in den Figuren 3a und 3b in ihrer Projektion in die X,Z-Ebene dargestellt. Auf die Y-Komponente 3 von Figur 2b hat der um die Y-Achse drehende 180°-Impuls die gleiche Wirkung wie die Impulse einer Carr-Purcell-Gill-Meiboom-Impulsfolge. Für diese Impulsfolge ist charakteristisch, daß nicht nur die Phasenfehler ausgeglichen werden, die auf unterschiedliche Larmorfrequenzen infolge von Magnetfeld-Inhomögenitäten zurückzuführen sind, sondern daß im Verlauf der Impulsfolge auch die Fehler kompensiert werden, welche dadurch entstehen, daß aufgrund mangelhafter Justierung der Pulslänge oder einer örtlichen

Variation der $H_1$-Feldstärke bestimmte Spinmomente durch einen «180°-Impuls» tatsächlich um einen kleineren oder größeren Winkel als 180° gedreht werden. Wie diese Kompensation stattfindet, zeigt Figur 3a. Die zu geringe Drehung von 11 nach 12 durch den Impuls 5 wird durch die Verschiebung des Ausgangspunktes in 13 kompensiert, so daß nach dem nächsten 180°-Impuls 7 beim Echosignal 8 (Fig. 1) das Spinmoment wieder in der X,Y-Ebene liegt (Pos. 14). Anders verhält es sich bei der X-Komponente 4 von Figur 2b des Spinmomentes gemäß Figur 3b. Hier schließt sich an die Drehung von der Pos. 21 zur Pos. 22 die ebenfalls zu kleine Drehung von der Pos. 23 zur Pos. 24 an, wodurch sich der Phasenfehler vergrößert. Die Folge davon ist, daß bei Anwendung einer Carr-Purcell-Gill-Beiboom-Impulsfolge nach Figur 1 der aus der X-Komponente hervorgehende Signalanteil binnen kurzem völlig verschwindet und nur der aus der Y-Komponente hervorgehende Signalanteil übrig bleibt. Würde eine um die X-Achse drehende Impulsfolge verwendet, so träte die Kompensation bezüglich des aus der X-Komponente hervorgehenden Signalanteils auf, während der aus der Y-Komponente hervorgehende Signalanteil verschwinden würde.

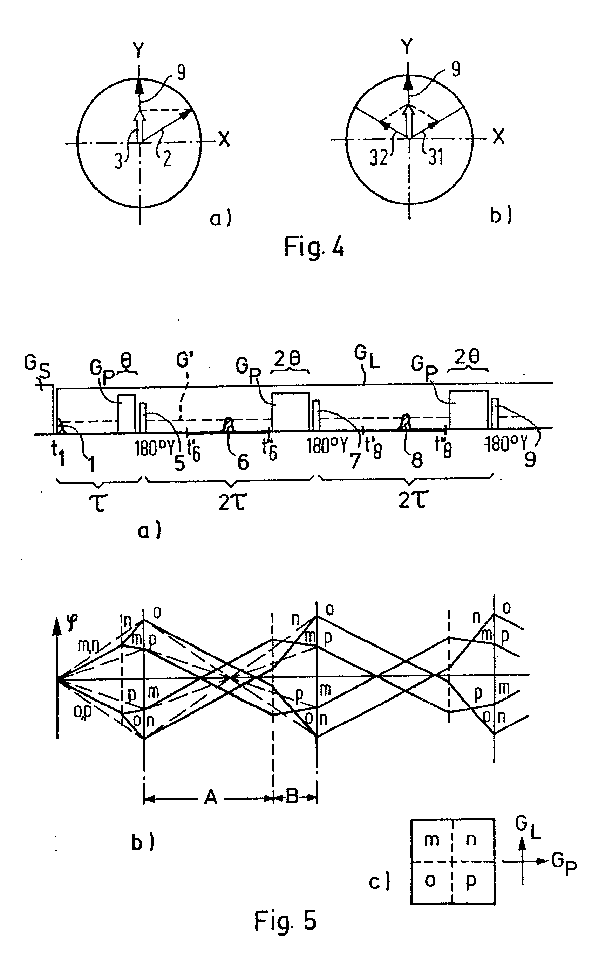

Bei dem im Figur 1 dargestellten, dem Stand der Technik entsprechenden Ausführungsbeispiel einer Spinecho-Impulsfolge (Carr-Purcell-Gill-Meiboom-Impulsfolge) sei daher angenommen, daß aufgrund der stets vorhandenen Abweichungen des Drehwinkels von 180° der aus der X-Komponente hervorgehende Signalanteil im Verlauf einiger Echos verschwindet. Dadurch tritt ein Informationsverlust ein, und der allein verbleibende, aus der Y-Komponente hervorgegangene Signalanteil wird so gedeutet, als ob zum Zeitpunkt $t_2$ anstelle des Spinmoments 2 mit der richtig kodierten Phasenlage (Fig. 4a) zwei aus der ursprünglichen Phasenlage 1 in Y-Richtung durch gegensinnige Phasendrehung unter dem Phasenkodierungsgradienten hervorgegangene Spinmomente 31, 32 von jeweils der halben Stärke von 2 vorhanden wären, deren Resultierende die Y-Komponente 3 ist (Fig. 4b). Die Komponenten 31, 32 der Spinmomente ergeben die Spiegelbilder, welche das tatsächliche Querschnittsbild völlig verfälschen und daher bisher die Anwendung von Spinecho-Impulsfolgen bei der 2DFT-Technik unmöglich machten. In gleicher Weise treten Spiegelbilder auch bei den anderen bekannten Spinecho-Impulsfolgen auf, bei denen die Phasenlage der 180°-Impulse gleichbleibt oder einfach alterniert.

Die vorstehend geschilderten Zusammenhänge kann man darin zusammenfassen, daß die Ursache der Spiegelbilder beim 2DFT-Verfahren in der Dephasierung der Spinmomente unter der einmaligen Einwirkung der Phasenkodierungsgradienten zwischen den Zeiten $t_1$ und $t_2$ von Figur 1 liegt. Da der Phasenkodierungsgradient bei den bekannten Verfahren zwischen den 180°-Impulsen nicht erneut eingeschaltet wird, findet hinsichtlich dieser Dephasierung im Gegensatz zu der unter dem Einfluß des Lesegradienten erfolgten Dephasierung im Verlaufe der Spinecho-Impulsfolge keine Rephasierung statt, d.h. daß die Rephasierungsbedingung nur für den Lesegradienten, nicht jedoch für den Phasenkodierungsgradienten erfüllt ist. Die Ausgangsphasenlage, gegenüber welcher im Verlaufe der in Figur 1 dargestellten Spinecho-Impulsfolge die Rephasierung erfolgt, ist daher die Phasenlage der Spinmomente zum Zeitpunkt $t_2$. Da diese Phasenlage in der Regel nicht mit der Y-Richtung übereinstimmt (vgl. Fig. 2), ist mit den bekannten Spinecho-Impulsfolgen aus den geschilderten Gründen keine vollständige Kompensation der 180°-Fehler möglich.

Diese Zusammenhänge waren nicht bekannt und auch keineswegs offensichtlich. Es bedurfte vielmehr sehr intensiver Untersuchungen, um zu einer Erklärung für die Spiegelbilder zu kommen. Aufgrund der vorstehend dargelegten Deutung der Entstehung der Spiegelbilder läßt sich nun auch ein Verfahren angeben, wie diese Spiegelbilder vermeidbar sind.

Dieses Verfahren besteht einfach darin, zwischen je zwei 180°-Impulsen der Spinecho-Impulsfolge den Phasenkodierungsgradienten erneut für eine bestimmte Zeit einzuschalten, und zwar so, daß die durch die Einwirkung des Phasenkodierungsgradienten zwischen je zwei 180°-Impulsen bewirkten Dephasierungen doppelt so groß sind wie die durch die Einwirkung des Phasenkodierungsgradienten vor dem ersten 180°-Impuls bewirkte Dephasierung. Dies kann z.B. bei gleicher Stärke des Phasenkodierungsgradienten durch eine doppelt so große Einwirkungsdauer geschehen oder auch bei gleicher Einwirkdauer durch doppelte Gradientenstärke. Dabei ist der Phasenkodierungsgradient so zu schalten, daß die von diesem Gradienten bewirkte Dephasierung während der Dauer jedes Meßvorganges konstant und für alle Meßvorgänge innerhalb einer Spinecho-Impulsfolge dieselbe ist.

Eine mögliche Ausführungsform des erfindungsgemäßen Verfahrens ist in Figur 5 dargestellt. Hierbei wird zunächst zwischen als Zeitpunkt $t_1$ bezeichnetem Ende der Selektionsphase und dem ersten 180°-Impuls 5 bei anliegendem Lesegradient $G_L$ der Phasenkodierungsgradient $G_P$ für eine Dauer θ eingeschaltet, wobei die Stärke von $G_P$ oder auch die Dauer θ im Verlauf der für die Aufnahme eines Bildes nach dem 2DFT-Verfahren benötigten Vielzahl von Anregungen der Spinmomente variiert werden. (Da die Dephasierungen unter der Einwirkung mehrerer Gradienten voneinander unabhängig sind, ist es zur Zeitersparnis vorteilhaft, wie in Figur 5 dargestellt, den Phasenkodierungsgradienten und den Lesegradienten gemeinsam anzulegen.) Eine Zeit τ nach dem Zeitpunkt $t_1$ erfolgt dann der erste 180°-Impuls 5. Eine weitere Zeit τ nach dem Impuls 5 erscheint das Echo 6, dessen Signalverlauf zwischen $t_6'$ und $t_6''$ bei anliegendem Lesegradienten gemessen wird. Zwischen dem Endzeitpunkt $t_6''$ der Datenerfassung und dem nächsten 180°-Impuls 7, welcher im zeitlichen Abstand 2τ auf den 180°-Impuls 5 folgt, wird für die Dauer 2θ der Phasenkodierungsgradient zusätzlich zum Lesegradienten eingeschaltet. Der beschriebene Zyklus zwischen den Impulsen 5 und 7 wird dann entsprechend der für die Bildaufnahme gewünschten Zahl von Echos wiederholt. Dabei entspricht die Phasenlage der HF-Impulse einer herkömmlichen Carr-Purcell-Gill-Meiboom-Sequenz, d.h., bei Anregung durch einen 90°,X-Impuls handelt es sich bei den 180°-Impulsen um Y-Impulse.

Die Wirkung der Gradientenfelder auf den zeitlichen Phasenverlauf ist in Figur 5b dargestellt. Betrachtet werden vier in der Ebene die Viertel eines Quadrates bildende Volumenelemente m, n, o, p, von denen die Elemente m, n sowie o, p längs der Richtung des Phasenkodierungsgradienten und die Elemente n, o bzw. n, p längs der Richtung des Lesegradienten nebeneinander liegen. Im Anschluß an die Zeit $t_1$ sehen die Volumenelemente m, n infolge der Wirkung des Lesegradienten $G_L$ ein anderes magnetisches Feld als die Volumenelemente o, p. Demgemäß haben die Spins der ersten beiden Volumenelemente eine andere Larmorfrequenz als die Spins der letztgenannten beiden Volumenelemente. Es entstehen daher Phasenunterschiede zwischen den zur Zeit $t_1$ phasengleichen Spinmomenten, die mit der Zeit zunehmen. Während die Phase der Spinmomente der Volumenelemente m, n für das in der Zeichnung dargestellte Beispiel gegenüber der Nullphase vorlaufen, bleibt die Phase der Spinmomente der Volumenelemente o, p gegenüber der Nullphase zurück. Bei Einsetzen des Phasenkodierungsgradienten $G_P$ findet zusätzlich ein Auseinanderlaufen der Phasen zwischen den Volumenelementen m und n bzw. zwischen o und p statt. Durch den ersten 180°-Impuls 5 findet eine Phasenumkehr (Spiegelung an der Phasenlage Y) statt, worauf dann während des Zeitraumes A eine Phasenentwicklung wiederum nur unter dem Lesegradienten $G_L$ und anschliessend während des Zeitraumes B für die Dauer 2θ unter beiden Gradienten stattfindet. Es ist ersichtlich, daß auf diese Weise zur Zeit des 180°-Impulses 7 wieder genau die gleichen Phasenverhältnisse herrschen wie zu Beginn des Zeitabschnittes A bei Auftreten des ersten 180°-Impulses. Die weitere Entwicklung ist stets die gleiche.

Die gesamte Dephasierungswirkung zu den Zeitpunkten der 180°-Impulse ist genau die gleiche, als wenn der Phasenkodierungsgradient $G_P$ in Form eines konstanten resultierenden Gradienten G' eingeschaltet gewesen wäre. (Der zeitliche Verlauf der Dephasierung in diesem hypothetischen, nur der Veranschaulichung dienenden Fall ist in Figur 5b gestrichelt eingezeichnet.) Das beschriebene Verfahren stellt also durch die Einhaltung der Rephasierungsbedingung auch für den Phasenkodierungsgradienten dieselben Verhältnisse wie bei einer herkömmlichen Carr-Purcell-Gill-Meiboom-Sequenz her. Daher ist auch die kompensierende Wirkung der konventionellen CPGM-Sequenz voll vorhanden.

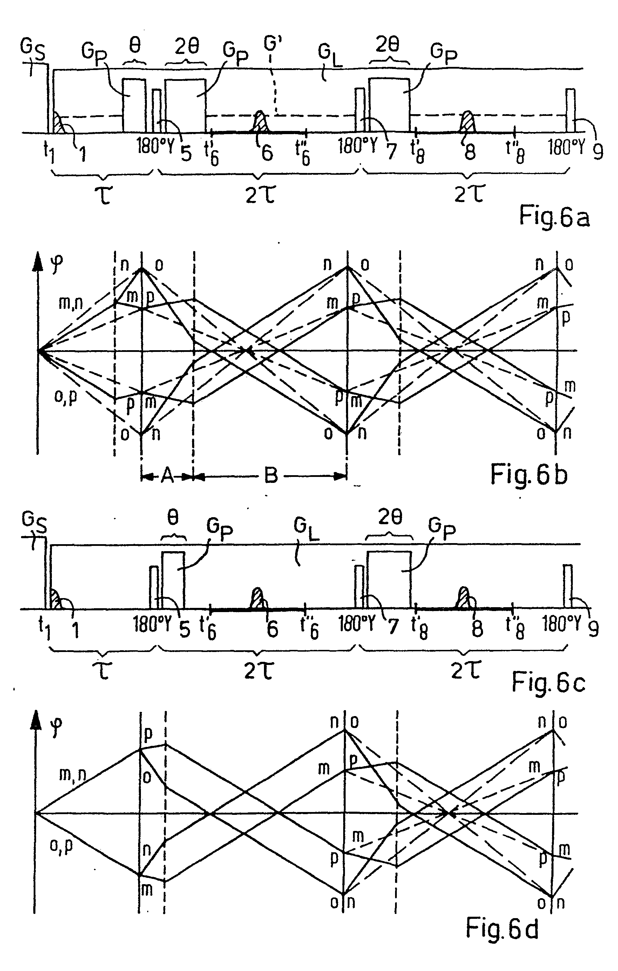

Eine zweite Ausführungsform des erfindungsgemäßen Verfahrens ist in Figur 6 dargestellt. Hierbei erfolgt ein Wiedereinschalten des Phasenkodierungsgradienten mit der Dauer 2θ jeweils zwischen dem Ende des 180°-Impulses 5, 7 usw. und dem Beginn $t_6'$, $t_8'$ usw. des darauffolgenden Meßvorgangs. Aus dem in Figur 6b dargestellten seitlichen Phasenverlauf ist sofort ersichtlich, daß auch in diesem Fall die Rephasierungsbedingung für beide Gradienten erfüllt ist.

In einer Abwandlung der in den Figuren 6a und 6b dargestellten Ausführungsform kann man auch auf das erste Einschalten des Phasenkodierungsgradienten vor dem ersten 180°-Impuls 5 verzichten, und den Phasenkodierungsgradienten zwischen dem 180°-Impuls 5 und dem Beginn $t'_6$ des ersten Meßvorgangs stattdessen nur für die einfache Dauer θ einschalten. Diese Abwandlung, bei der die Rephasierungsbedingung für den Phasenkodierungsgradienten erst ab dem zweiten 180°-Impuls 7 erfüllt ist, ist in den Figuren 6c und 6d dargestellt. Man erkennt aus Figur 6d, daß die Dephasierungen während des ersten und der darauffolgenden Meßvorgänge dieselben sind wie bei der in den Figuren 6a und 6b dargestellten Ausführungsform.

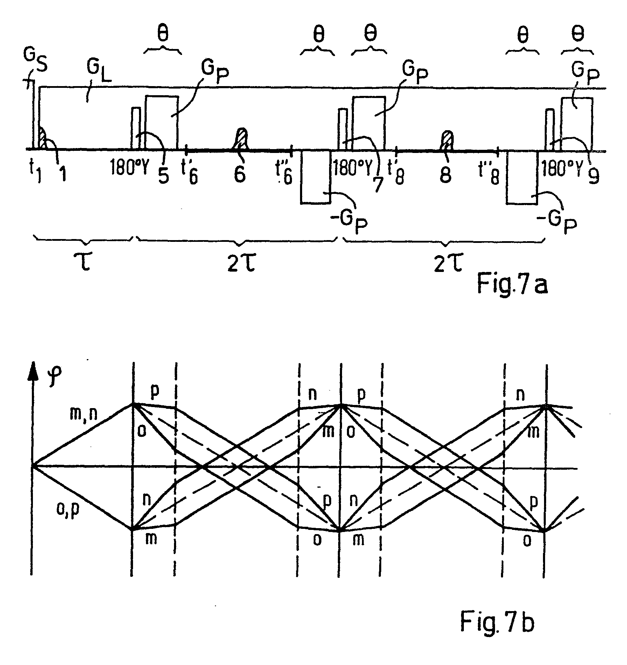

Eine dritte Ausführungsform des Verfahrens ist in Figur 7 dargestellt. Bei dieser Ausführungsform bleibt der Phasenkodierungsgradient vor Beginn des ersten 180°-Impulses ausgeschaltet. Infolgedessen erfolgt während dieses Zeitraums keine Dephasierung unter dem Phasenkodierungsgradienten. Zur Einhaltung der Rephasierungsbedingung muß sich daher auch die Dephasierung unter dem Phasenkodierungsgradienten zwischen je zwei benachbarten 180°-Impulsen aufheben. Dies wird in der dargestellten Ausführungsform dadurch erreicht, daß der Phasenkodierungsgradient jeweils vor Beginn $t'_6$, $t'_8$ usw. des Meßvorgangs für eine Dauer θ eingeschaltet wird und nach Ende $t''_6$, $t''_8$ usw. des Meßvorgangs für dieselbe Dauer θ, jedoch mit umgekehrtem Vorzeichen, erneut eingeschaltet wird.

Die letztgenannte, dritte Ausführungsform des erfindungsgemäßen Verfahrens hat den Vorteil, daß der zeitliche Abstand zweier 180°-Impulse durch die Einhaltung der Rephasierungsbedingung für den Phasenkodierungsgradienten nur um die Zeit 2 θ, gegenüber 4 θ bei den beiden anderen Ausführungsformen, verlängert werden muß, was einer besonders günstigen Ausnutzung der gesamten Meßzeit gleichkommt.

Ein weiterer Vorteil aller Ausführungsformen des erfindungsgemäßen Verfahrens besteht darin, daß die aus zwei aufeinanderfolgenden Echos gewonnenen Bilder im Gegensatz zu den bekannten Verfahren zur Erzeugung von Spinechos beim 2DFT-Verfahren nicht spiegelbildlich sind, so daß eine Umkehr der Bilder entfällt.

Das erfindungsgemäße Verfahren wurde an einem Phantom erprobt und lieferte ausgezeichnete, praktisch spiegelfreie Bilder.

## Patentansprüche

1. Verfahren zum Anregen einer Probe für die NMR-Tomographie, bei dem die Probe außer einem homogenen Magnetfeld einem Selektionsgradienten ausgesetzt und mit einem 90°-Selektionsimpuls angeregt, danach der Selektionsgradient durch einen zeitlich begrenzten Phasenkodierungsgradienten und einen Lesegradienten ersetzt, wobei Selektionsgradient, Phasenkodierungsgradient und Lesegradient jeweils paarweise zueinander senkrecht stehen und schließlich die Probe nach Beendigung der Phasenkodierungsgradienten bei herrschendem Lesegradienten mit einer Folge von 180°-Impulsen bestrahlt wird, wodurch mehrere Kerninduktionssignale in Form sogenannter Spinechos erzeugt werden, dadurch gekennzeichnet, daß die durch die Einwirkungen des Phasenkodierungsgradienten und des Lesegradienten zwischen je zwei 180°-Impulsen bewirkten Dephasierungen doppelt so groß sind wie die durch die Einwirkungen dieser beiden Gradienten vor dem ersten 180°-Impuls bewirkten Dephasierungen.

2. Verfahren nach Anspruch 1, dadurch gekennzeichnet, daß die Einwirkungszeit des Phasenkodierungsgradienten in die Zeit zwischen Ende der Datenaufnahme und dem Beginn des nachfolgenden 180°-Impulses fällt.

3. Verfahren nach Anspruch 1, dadurch gekennzeichnet, daß die Einwirkungszeit der Phasenkodierungsgradienten in die Zeit zwischen dem Ende des 180°-Impulses und dem Beginn der nachfolgenden Datenaufnahme fällt.

4. Verfahren nach Anspruch 2 oder 3, dadurch gekennzeichnet, daß die Einwirkung des Phasenkodierungsgradienten zwischen je zwei 180°-Impulsen mit gleicher Stärke, jedoch doppelt so großer Dauer erfolgt wie die Einwirkung des Phasenkodierungsgradienten vor Beginn des ersten 180°-Impulses.

5. Verfahren nach Anspruch 2 oder 3, dadurch gekennzeichnet, daß die Einwirkung des Phasenkodierungsgradienten zwischen je zwei 180°-Impulsen mit gleicher Dauer, jedoch doppelt so großer Stärke erfolgt wie die Einwirkung des Phasenkodierungsgradienten vor Beginn des ersten 180°-Impulses.

6. Verfahren zum Anregen einer Probe für die NMR-Tomographie, bei dem die Probe außer einem homogenen Magnetfeld einem Selektionsgradienten ausgesetzt und mit einem 90°-Selektionsimpuls angeregt, danach der Selektionsgradient durch einen zeitlich begrenzten Phasenkodierungsgradienten und einen Lesegradienten ersetzt wird, wobei Selektionsgradient, Phasenkodierungsgradient und Lesegradient jeweils paarweise zueinander senkrecht stehen und schließlich die Probe bei herrschendem Lesegradienten mit einer Folge von 180°-Impulsen bestrahlt wird, wodurch mehrere Kerninduktionssignale in Form sogenannter Spinechos erzeugt werden, dadurch gekennzeichnet, daß der Phasenkodierungsgradient erstmals nach dem ersten 180°-Impuls eingeschaltet und dann in der Weise periodisch angelegt wird, daß er zwischen je zwei 180°-Impulsen zunächst für eine erste bestimmte Zeitdauer vor Beginn des Meßvorgangs eingeschaltet wird und anschließend nach Ende des Meßvorgangs, jedoch vor Beginn des nachfolgenden 180°-Impulses nochmals für eine zweite bestimmte Zeitdauer eingeschaltet wird, so daß sich die während dieser beiden Einwirkzeiten bewirkten Dephasierungen gegenseitig aufheben.

7. Verfahren nach Anspruch 6, dadurch gekennzeichnet, daß die Einwirkung des Phasenkodierungsgradienten vor und nach dem Meßvorgang mit gleicher Dauer und Stärke, jedoch unterschiedlichem Vorzeichen erfolgt.

## Claims

1. A method of stimulating a specimen for NMR tomography, in which the specimen is exposed not only to an homogeneous magnetic field but to a selection gradient and is stimulated with a 90° selection pulse, after which the selection gradient is replaced by a time-limited phase coding gradient and a reading gradient, selection gradient, phase coding gradient and reading gradient being in each case paired and perpendicular to one another, the specimen, upon completion of the phase coding gradient and while the reading gradient is prevailing, being finally irradiated with a sequence of 180° pulses so that a plurality of nuclear magnetic resonance (NMR) signals in the form of so-called spin echoes are generated, characterised in that the dephasings brought about by the effects of the phase coding gradient and the reading gradient between any 280° pulses are twice as great as the dephasings produced by the effects of these two gradients upstream of the first 180° pulse.

2. Method according to Claim 1, characterised in that the period of action of the phase coding gradient falls in the time between the end of data input and commencement of the next 180° pulse.

3. Method according to Claim 1, characterised in that the period of action of the phase coding gradient falls in the time between the end of the 180° pulse and the commencement of the next data input.

4. Method according to Claim 2 or 3, characterised in that the action of the phase coding gradient between any two 180° pulses of equal strength but of twice the duration, takes place prior to commencement of the first 180° pulse, like the action of the phase coding gradient.

5. Method according to Claim 2 or 3, characterised in that the action of the phase coding gradient between any two 180° pulses of equal duration but of twice the strength takes place prior to commencement of the first 180° pulse, like the action of the phase coding gradient.

6. Method of stimulating a specimen for NMR tomography in which the specimen is exposed not only to an homogeneous magnetic field but also to a section gradient and is stimulated with a 90° selection pulse, after which the selection gradient is replaced by a time-limited phase coding gradient and a reading gradient, selection gradient, phase coding gradient and reading gradient being in each case paired and perpendicular to one another, and in that, under a prevailing reading gradient, the specimen is irradiated with a sequence of 180° pulses, so that a plurality of nuclear magnetic resonance (NMR) signals in the form of so-called spin echoes are generated, characterised in that the phase coding gradient is switched on for the first time following the first 180° pulse and is then applied periodically in such a way that it is switched on between any two 180° pulses initially for a first specific period prior to commencement of the measuring process and then, on completion of the measuring process but prior to commencement of the subsequent 180° pulse, is switched on once again for a second specific period so that dephasings which occur during these two action times are mutually cancelling.

7. Method according to Claim 6, characterised in that the action of the phase coding gradient before and after the measuring process occurs with equal duration and intensity but with a different precedent sign.

## Revendications

1. Procédé pour exciter un échantillon ou objet à examiner par tomographie R.M.N., selon lequel on expose l'objet à un champ magnétique homogène et en plus à un gradient de sélection et on l'excite par une impulsion de sélection de 90°, on remplace ensuite le gradient de sélection par un gradient de codage de phase limité dans le temps et un gradient de lecture, le gradient de sélection, le gradient de codage de phase et le gradient de lecture étant perpendiculaires par paire, et on irradie enfin l'objet, après avoir fait cesser le gradient de codage de phase et pendant que le gradient de lecture reste appliqué, avec une succession d'impulsions de 180°, ce qui engendre plusieurs signaux d'induction nucléaire sous forme de ce que l'on appelle des échos de spin, caractérisé en ce que les déphasages provoqués entre chaque fois deux impulsions de 180°, sous les actions du gradient de codage de phase et du gradient de lecture, sont deux fois plus grands que les déphasages provoqués par les actions de ces deux gradients avant la première impulsion de 180°.

2. Procédé selon la revendication 1, caractérisé en ce que le temps d'action du gradient de codage de phase tombe dans le temps compris entre la fin de la saisie de données et le début de l'impulsion de 180° suivante.

3. Procédé selon la revendication 1, caractérisé en ce que le temps d'action du gradient de codage de phase tombe dans le temps compris entre la fin de l'impulsion de 180° et le début de la saisie de données consécutive.

4. Procédé selon la revendication 2 ou 3, caractérisé en ce que le gradient de codage de phase agit avec la même intensité mais avec une durée double entre chaque fois deux impulsions de 180°, comparativement à l'action de ce gradient avant le début de la première impulsion de 180°.

5. Procédé selon la revendication 2 ou 3, caractérisé en ce que le gradient de codage de phase agit avec la même durée mais avec une double intensité entre chaque fois deux impulsions de 180°, comparativement à son action avant le début de la première impulsion de 180°.

6. Procédé pour exciter une échantillon ou objet à examiner par tomographie R.M.N., selon lequel on expose l'objet à un champ magnétique homogène et en plus à un gradient de sélection et on l'excite par une impulsion de sélection de 90°, on remplace ensuite le gradient de sélection par un gradient de codage de phase limité dans le temps et un gradient de lecture, le gradient de sélection, le gradient de codage de phase et le gradient de lecture étant perpendiculaires par paire, et on irradie enfin l'objet, après avoir fait cesser le gradient de codage de phase pendant que le gradient de lecture reste appliqué, avec une succession d'impulsions de 180°, ce qui engendre plusieurs signaux d'induction nucléaire sous forme de ce que l'on appelle des échos de spin, caractérisé en ce que l'on enclenche le gradient de codage de phase pour la première fois après la première impulsion de 180° et on l'applique ensuite périodiquement, de manière que, entre chaque fois deux impulsions de 180°, il soit enclenché d'abord pendant une première durée prédéterminée avant le début de l'opération de mesure et qu'il soit ensuite enclenché une nouvelle fois après la fin de l'opération de mesure, mais avant le début de l'impulsion de 180° consécutive, de manière que les déphasages provoqués pendant ces deux temps d'action s'annulent mutuellement.

7. Procédé selon la revendication 6, caractérisé en ce que le gradient de codage de phase agit avant et après l'opération de mesure avec les mêmes durées et intensités, mais avec des signes différents.

0 158 965

Fig. 1

Fig. 2

Fig. 3

9

Fig. 4

a)

b)

c)

Fig. 5

0 158 965

Fig. 6a

Fig. 6b

Fig. 6c

Fig. 6d

13

Fig. 7 a

Fig. 7 b